# DEMANDE DE BREVET EUROPEEN

(11) **EP 1 536 559 A1**
(43) Date de publication de la demande: **01.06.2005**
(21) Numéro de dépôt: 03027066.4
(22) Date de dépôt: 25.11.2003
(51) Int. Cl.: H03H 9/10, H03H 3/04

(54) **Composant électronique ayant un élément résonateur dans un boitier hermetiquement fermé**

(71) Demandeur: ETA SA Manufacture Horlogère Suisse, 2540 Grenchen (CH)
(72) Inventeur: Dalla Piazza, Silvio, 2610 Saint-Imier (CH); Lüthi, Thomas, 2540 Grenchen (CH)
(74) Mandataire: Laurent, Jean

(57) **Abrégé**

Le composant électronique (1) comprend au moins un élément résonateur (5) disposé dans un logement (8) d'un boîtier. Le boîtier comprend une partie principale (2) avec une base (20) et au moins une paroi latérale (3) de forme annulaire, et un couvercle (4) fixé sur la partie principale pour fermer hermétiquement le logement du boîtier. Une portion du couvercle est transparente à une longueur d'onde déterminée d'un faisceau de lumière pour permettre un réglage optique de l'élément résonateur une fois que le boîtier est fermé. Ce couvercle est fixé sur un rebord (7) de la paroi latérale (3) de la partie principale de manière qu'une partie du rebord entoure de préférence intégralement la surface latérale du couvercle (4) pour assurer une protection du composant électronique contre des chocs latéraux.

## Description

La présente invention concerne un composant électronique ayant un élément résonateur dans un boîtier hermétiquement fermé. Ledit boîtier comprend une partie principale avec une base et au moins une paroi latérale de forme annulaire, et un couvercle fixé sur la partie principale. Au moins une portion du couvercle est transparente à une longueur d'onde déterminée d'un faisceau de lumière pour permettre un réglage optique de l'élément résonateur.

L'élément résonateur peut être par exemple un résonateur piézo-électrique, tel qu'un résonateur à quartz destiné à être relié à un circuit oscillateur. La plupart des résonateurs à quartz de petites dimensions, qui sont utilisés par exemple dans les montres électroniques ou électromécaniques, sont des résonateurs à diapason en quartz. Ces résonateurs à quartz sont habituellement enfermés sous vide dans des boîtiers, dans le cas de la génération de signaux basse fréquence fournis par le circuit oscillateur, ou sous atmosphère de gaz inerte.

Généralement, de tels résonateurs sont montés dans des boîtiers par exemple en céramique qui sont relativement plats. Ces boîtiers comprennent généralement une partie principale de forme parallélépipédique à l'intérieur de laquelle est monté le résonateur, et un couvercle rectangulaire fixé sur la partie principale. Si le résonateur est enfermé sous vide dans le boîtier, le réglage dudit résonateur peut être réalisé optiquement à travers le couvercle transparent.

On peut citer à ce titre le document JP 54-35870 U qui décrit un composant électronique avec un élément résonateur qui est disposé dans un premier logement d'une partie principale d'un boîtier. Ce premier logement est fermé hermétiquement par un couvercle transparent fixé à l'aide d'une préforme sur un bord annulaire du premier logement de la partie principale. Un circuit intégré oscillateur est disposé dans un second logement de la partie principale du boîtier qui est séparé du premier logement par une base. Le second logement est fermé par un couvercle opaque fixé sur un bord annulaire du second logement de la partie principale. Le circuit intégré est relié électriquement à l'élément résonateur à travers la base de la partie principale du boîtier.

Un inconvénient d'un tel composant électronique décrit dans le document JP 54-35870 U est que, lors de chocs latéraux au niveau de chaque couvercle, des fissures du couvercle ou du matériau fixant le couvercle sur la partie principale peuvent survenir, induisant ainsi une perte d'étanchéité. Ces chocs latéraux peuvent intervenir lors de diverses manipulations, notamment lors des opérations de montage dudit composant électronique dans un appareil électronique ou sur une plaque de circuit imprimé. Comme habituellement l'élément résonateur doit rester enfermé sous vide dans son boîtier ou dans une atmosphère de gaz inerte, le réglage de l'élément résonateur pour la génération de signaux à fréquence déterminée du circuit oscillateur peut être faussé. Le résonateur peut même cesser d'osciller. Pour minimiser ces problèmes, il est nécessaire de meuler les coins et les faces latérales des couvercles par des procédés spéciaux. Bien entendu, ceci augmente sensiblement le coût de tels couvercles.

Un autre inconvénient du composant électronique du document JP 54-35870 U est purement lié au procédé de fermeture. En effet, la technique communément employée pour le fermeture du boîtier est d'empiler les différents éléments dans une cavité d'une plaque métallique, à savoir la préforme sur la partie principale du boîtier, et le couvercle sur la préforme. Ainsi, les trois éléments sont positionnés précisément. Pour ce faire, la tolérance mécanique de cette cavité doit être très grande de façon à bien positionner les trois éléments.

L'invention a donc pour but principal de pallier les inconvénients de l'art antérieur en fournissant un composant électronique ayant un élément résonateur enfermé hermétiquement dans un boîtier dont le couvercle est protégé des chocs latéraux. De plus, le temps et les coûts de fabrication d'un tel composant électronique avec un couvercle du boîtier protégé peuvent être minimisés.

A cet effet, l'invention concerne un composant électronique cité ci-devant qui se caractérise en ce que le couvercle est fixé sur un rebord de la paroi latérale de la partie principale de manière qu'une partie du rebord entoure au moins partiellement la surface latérale du couvercle pour assurer une protection du composant électronique contre des chocs latéraux.

Un avantage du composant électronique selon l'invention est qu'avec un tel rebord dont une partie entoure partiellement la surface latérale du couvercle pour le protéger des chocs latéraux, le composant électronique peut être manipulé sans risque. De préférence, une partie du rebord entoure intégralement la surface latérale du couvercle. Ceci permet de maintenir l'élément résonateur enfermé hermétiquement dans son logement par le couvercle dans une atmosphère de gaz inerte ou préférentiellement sous vide. De même, le positionnement du couvercle par rapport à la partie principale du boîtier ne dépend plus de la tolérance mécanique de cavités utilisées dans le procédé de fermeture du boîtier. Ceci réduit ainsi les risques d'un mauvais alignement du couvercle sur le rebord.

La hauteur de la partie du rebord qui entoure la surface latérale du couvercle est préférentiellement égale ou plus grande que l'épaisseur du couvercle fixé sur le rebord, pour qu'aucune arête du couvercle ne soit en saillie de la face supérieure du rebord. Il peut être également laissé un espace entre cette partie du rebord et la surface latérale du couvercle pour assurer une meilleure protection. De cette façon, les chocs latéraux survenant contre le rebord ne se propagent pas directement contre le couvercle. Ainsi, il peut être utilisé un couvercle transparent par exemple en verre, qui est obtenu simplement par rayage et cassage d'une plaque de verre traditionnelle. Ceci réduit les coûts de fabrication d'un tel composant électronique, car il n'est plus nécessaire de travailler spécialement les bords et les angles du couvercle réalisé en verre ou en un autre matériau qui peut être friable ou cassable.

Pour la fixation du couvercle sur le rebord, une première couche annulaire de dorure est tout d'abord déposée sur le rebord, ainsi qu'une seconde couche annulaire de dorure déposée en périphérie d'une face intérieure du couvercle. Une préforme en alliage métallique est disposée entre les deux couches annulaires de dorure pour fixer le couvercle par soudure en chauffant et pressant le couvercle contre le rebord. L'alliage métallique de la préforme utilisée peut être composé d'étain et d'or.

Dans le cas où l'élément résonateur doit être enfermé sous vide, il peut être évaporé dans le logement de l'élément résonateur un matériau du type getter, tel qu'une couche de titane ou de chrome. Après avoir hermétiquement fermé le logement de l'élément résonateur, la couche de chrome ou de titane peut être activée notamment chauffée par un faisceau laser pour ainsi servir de pompe à vide.

Les buts, avantages et caractéristiques du composant électronique ayant un élément résonateur apparaîtront mieux dans la description suivante d'au moins une forme d'exécution non limitative de l'invention en liaison avec les dessins dans lesquels :
La figure 1 représente une vue de dessus du composant électronique selon l'invention, et
la figure 2 représente une vue en coupe selon A-A de la figure 1 du composant électronique selon l'invention.

Dans la description suivante, toutes les parties du composant électronique qui sont bien connues d'un homme du métier dans ce domaine technique, ne seront pas expliquées en détail.

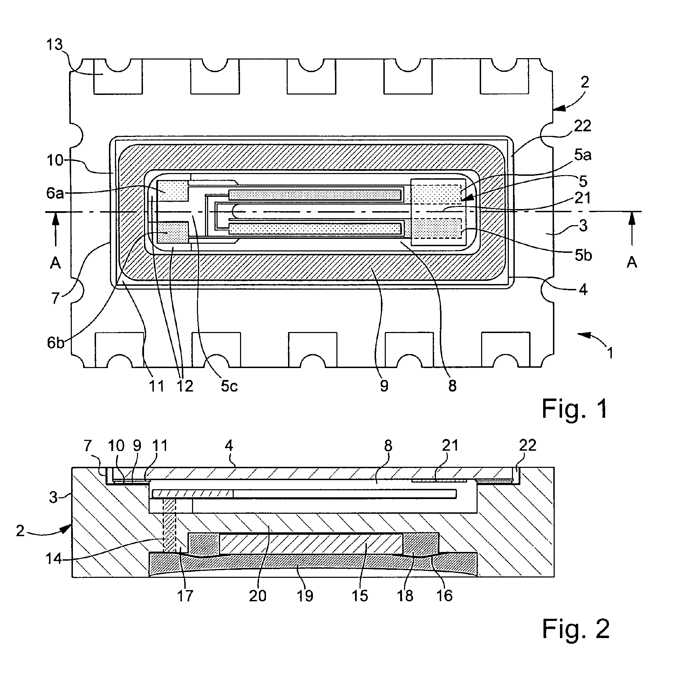

Le composant électronique 1 est représenté de manière simplifiée aux figures 1 et 2. Il comprend un élément résonateur 5 monté dans un premier logement 8 d'un boîtier de forme parallélépipédique. Le boîtier comprend une partie principale 2 avec une paroi latérale de forme annulaire 3 et une base 20, et un couvercle 4 fixé sur un rebord 7 de la paroi latérale 3 pour fermer hermétiquement sous vide le logement 8 de la partie principale. Ce boîtier peut être par exemple de 5 mm de long, 3,2 mm de large et 1,08 mm de haut.

La paroi latérale 3, ainsi que la base 20 de la partie principale 2 du boîtier sont de préférence réalisées en céramique selon une technique traditionnelle. Pour ce faire, plusieurs feuilles de céramique sont normalement ouvragées, empilées et fixées les unes sur les autres pour réaliser la base 20 et la paroi latérale 3 en dessus et en dessous de la base.

Une partie du rebord 7 entoure intégralement le couvercle de forme rectangulaire de manière à le protéger de tous les chocs latéraux survenant sur le composant électronique. La hauteur de la partie du rebord 7, qui entoure le couvercle 4, est supérieure ou égale à l'épaisseur du couvercle une fois fixé sur ledit rebord. De cette façon, aucune arête du couvercle n'est en saillie en dehors du boîtier.

Grâce à ce rebord 7 de la partie principale 2, le composant électronique peut être manipulé sans aucun risque. Un espace 22 sépare la surface latérale du couvercle 4 de la partie du rebord 7 qui l'entoure. Cet espace 22 permet d'éviter de propager directement au couvercle des chocs latéraux pouvant survenir contre ledit rebord, qui sont susceptibles d'endommager le couvercle.

Le couvercle 4 de forme rectangulaire peut être avantageusement un couvercle en verre, qui est obtenu simplement par rayage et cassage d'une plaque de verre traditionnelle. Comme le couvercle est protégé par une partie du rebord 7, il n'est plus nécessaire de travailler spécialement les bords et les angles du couvercle, ce qui réduit les coûts de fabrication d'un tel composant électronique.

Pour la fixation du couvercle 4 sur le rebord 7, une première couche annulaire de dorure 10 est déposée par évaporation, ou par une autre méthode, sur le côté intérieur du rebord 7, et une seconde couche annulaire de dorure 11 est déposée par évaporation, ou par une autre méthode, à la périphérie d'une face intérieure du couvercle 4. Cette seconde couche annulaire 11 n'est pas représentée à la figure 1 de manière à ne pas surcharger le dessin. Une préforme annulaire 9 en alliage métallique est disposée entre les deux couches annulaires de dorure 10 et 11 afin de pouvoir souder le couvercle 4 sur le rebord 7 en chauffant sous vide et pressant le couvercle 4 contre le rebord 7. Cette préforme est par exemple en alliage eutectique d'or et d'étain afin d'avoir une température de fusion supérieure à la température utilisée dans les procédés de montage subséquent du composant électronique 1.

L'élément résonateur 5, enfermé sous vide dans le logement 8 de la partie principale 2, est de préférence un résonateur piézo-électrique, qui comprend un diapason en quartz. Ce diapason en quartz classique est constitué de deux branches parallèles 5a et 5b pour vibrer en mode de flexion, qui sont maintenues à leur base par un pont 5c. Des couches de métallisation sont déposées sur chaque branche 5a et 5b et sur le pont 5c pour constituer deux groupes d'électrodes 6a et 6b afin de les soumettre à des champs électriques susceptibles de faire vibrer lesdites branches 5a et 5b. Le pont 5c est fixé dans un coin du logement 8 sur deux plots 12 venant de matière avec la base 20 et la paroi latérale 3 pour laisser un espace aux branches 5a et 5b pour vibrer dans le logement 8 entre la base 20 et le couvercle 4.

Pour plus de détails sur la réalisation ou le fonctionnement d'un tel résonateur, le lecteur se reportera à l'enseignement tiré des demandes de brevet européen EP 1 111 770 A1 et EP 1 303 042 A1.

L'ajustage ou le réglage du résonateur à quartz est réalisé classiquement sur le produit fini, c'est-à-dire quand le couvercle ferme hermétiquement sous vide le logement 8 du boîtier. Pour ce réglage, le couvercle 4 comprend au moins une portion transparente à une longueur d'onde déterminée d'un faisceau de lumière, tel qu'un faisceau laser. Ce couvercle peut être de préférence réalisé en verre comme décrit ci-devant, ou également en silicium qui est transparent aux longueurs d'ondes supérieures à 1,3 µm. Le faisceau laser utilisé dans ce cas doit donc être d'une longueur d'onde égale ou supérieure à 1,3 µm.

Dans cette forme d'exécution présentée aux figures 1 et 2, le composant électronique 1 comprend encore un second logement 18 dans la partie principale 2, qui est délimité par la paroi latérale 3 et la base 20. Ce second logement 18 est disposé sur une face opposée de la base par rapport au logement 8 de l'élément résonateur 5. Un circuit intégré 15 ayant un étage oscillateur est fixé sur la base 20 dans ce second logement 18.

Plusieurs plages métalliques du circuit oscillateur 15, non représentées, sont reliées de manière connue par des fils métalliques 16 à des plages métalliques internes du boîtier. Ces plages métalliques internes du boîtier, non représentées, sont disposées sur un support annulaire 17 venant de matière avec la paroi latérale 3 et la base 20. Ces plages métalliques internes sont reliées par des pistes de connexion, non représentées, à des bornes de connexion externes 13 disposées sur deux côtés du composant électronique 1.

Le second logement 18 est rempli d'une résine 19 pour encapsuler le circuit intégré 15 afin de le protéger mécaniquement et de la lumière. De cette façon, le composant électronique 1 terminé est configuré comme un composant de type SMD (sigle de l'appellation anglaise « Surface Mounting Device ») afin de pouvoir être monté par exemple sur une plaque de circuit imprimé.

Le circuit oscillateur 15 est également relié au résonateur à quartz 5 à travers la base 20 par deux pistes de connexion 14 de manière à produire des signaux à une fréquence dépendant de l'ajustage du résonateur. Ces pistes de connexion peuvent être réalisées en tungstène-nickel-or.

Pour la génération de signaux basse fréquence, le résonateur à quartz 5 doit être enfermé sous vide dans le logement 8 afin de pouvoir être ajusté ou réglé sur le composant électronique terminé par un faisceau laser comme décrit ci-devant. Cependant, il peut subsister une pression résiduelle dans le logement 8 de l'ordre de 1 mbar. De ce fait, une couche de chrome ou de titane 21 peut être déposée par exemple sur une partie de la face intérieure du couvercle 4 en tant que matériau du type getter. Cette couche de chrome ou de titane 21 peut servir de pompe à vide lorsqu'elle est activée notamment par un faisceau laser à travers le couvercle 4.

En activant cette couche 21 par faisceau laser, des particules de chrome ou de titane évaporées peuvent se déposer sur le résonateur et ainsi abaisser la fréquence d'oscillations. Par la suite, il est possible d'augmenter la fréquence du résonateur à ajuster en agissant directement sur les électrodes du résonateur.

Il est à noter que cette couche de chrome ou de titane 21 peut être déposée sur toute la face intérieure du couvercle 4 servant de couche d'accrochage pour la couche de dorure 11. De plus, la couche de chrome ou de titane peut être également placée à un autre endroit du logement 8, par exemple sur la base 20 ou sur le résonateur 5 pour autant qu'il soit possible de l'activer par un faisceau laser à travers le couvercle 4 du composant.

A partir de la description qui vient d'être faite de multiples variantes de réalisation du composant électronique peuvent être conçues par l'homme du métier sans sortir du cadre de l'invention définie par les revendications. Le composant électronique peut ne comprendre que l'élément résonateur.

Il peut être envisagé également de monter le circuit oscillateur dans le même logement que le résonateur à quartz. Ce circuit oscillateur peut comprendre également une fonction d'horloge à temps réel (RTC) ou d'autres fonctions.

Il peut être envisagé également de monter l'élément résonateur dans des boîtiers dont la partie principale peut être réalisée en métal ou en verre, comme cela a déjà été proposé pour des résonateurs à diapason classiques. Dans ce cas, il peut être prévu que la partie du rebord n'entoure que partiellement la surface latérale du couvercle par exemple les quatre coins du couvercle.

L'ajustage de l'élément résonateur peut être réalisé avant la fixation du couvercle sur le rebord de la paroi latérale du boîtier. Finalement, le logement comprenant l'élément résonateur peut ne pas comprendre de matériau du type getter.

## Revendications

1. Composant électronique (1) comprenant au moins un élément résonateur (5) disposé dans un logement (8) d'un boîtier, qui comprend une partie principale (2) avec une base (20) et au moins une paroi latérale (3) de forme annulaire, et un couvercle (4) fixé sur la partie principale pour fermer hermétiquement le logement du boîtier, au moins une portion du couvercle étant transparente à une longueur d'onde déterminée d'un faisceau de lumière pour permettre un réglage optique de l'élément résonateur, **caractérisé en ce que** le couvercle (4) est fixé sur un rebord (7) de la paroi latérale (3) de la partie principale de manière qu'une partie du rebord entoure au moins certaines portions de la surface latérale du couvercle (4) pour assurer une protection du composant électronique contre des chocs latéraux.

2. Composant électronique (1) selon la revendication 1, **caractérisé en ce que** la hauteur de la partie du rebord (7) entourant la surface latérale du couvercle (4) est plus grande ou égale à l'épaisseur du couvercle fixé sur le rebord, et **en ce que** la partie du rebord entoure intégralement la surface latérale du couvercle.

3. Composant électronique (1) selon la revendication 1, **caractérisé en ce que** le couvercle transparent (4) est un couvercle en verre, et **en ce que** la partie principale (2) du boîtier est en céramique.

4. Composant électronique (1) selon la revendication 1, **caractérisé en ce que** le rebord (7) de la partie principale (2) du boîtier recevant le couvercle comprend une première couche annulaire de dorure (10), **en ce que** la périphérie d'une face intérieure du couvercle comprend une seconde couche annulaire de dorure (11), et **en ce que** le couvercle (4) est soudé sur le rebord à l'aide d'une préforme (9) en alliage métallique disposée entre les deux couches annulaires de dorure, l'alliage métallique pouvant être composé d'étain et d'or.

5. Composant électronique (1) selon l'une des revendications 1 à 4, **caractérisé en ce qu'**il comprend un espace (22) entre la surface latérale du couvercle (4) et la partie du rebord (7) entourant le couvercle.

6. Composant électronique (1) selon la revendication 1, dans lequel le logement (8) de la partie principale (2) du boîtier, qui comprend l'élément résonateur (5), est fermé sous vide, **caractérisé en ce que** l'élément résonateur est un résonateur à quartz pouvant être réglé par un faisceau laser à travers la portion transparente du couvercle (4), ledit résonateur à quartz étant en forme de diapason avec deux branches parallèles (5a, 5b) reliées entre elles par un pont (5c) et portant des électrodes (6a, 6b) pour les faire vibrer, et **en ce que** la partie principale du boîtier comprend au moins un plot (12) solidaire de la base (20) sur lequel est fixé le diapason, lesdites électrodes étant reliées électriquement à travers la partie principale du boîtier à des bornes externes de connexion (13).

7. Composant électronique (1 ) selon la revendication 1, **caractérisé en ce qu'**il comprend un circuit oscillateur (15) connecté électriquement à l'élément résonateur (5).

8. Composant électronique (1) selon la revendication 7, **caractérisé en ce que** le circuit oscillateur (15) est disposé dans un second logement (18) de la partie principale (2), qui est délimité par la paroi latérale (3) et la base (20), le second logement étant disposé sur une face opposée de la base par rapport au logement (8) de l'élément résonateur (5), **en ce que** ledit circuit oscillateur, qui est encapsulé dans le second logement par une résine (19), est connecté électriquement à des bornes externes de connexion (13) du composant électronique, et **en ce que** la base de la partie principale du boîtier comprend des pistes de connexion électrique (14) pour relier électriquement le circuit oscillateur et l'élément résonateur.

9. Composant électronique (1) selon la revendication 1, **caractérisé en ce qu'**un matériau du type getter est disposé dans le logement (8) de l'élément résonateur (5) pour servir de pompe à vide lorsqu'il est activé.

10. Composant électronique (1) selon la revendication 9, **caractérisé en ce que** le matériau du type getter est une couche de titane ou de chrome (21) évaporée dans le logement (8) de l'élément résonateur, de préférence sur une partie de la face intérieure du couvercle (4), et **en ce que** cette couche de titane ou de chrome est susceptible d'être activée au moyen d'un faisceau laser à travers la portion transparente du couvercle (4) pour servir de pompe à vide.
